# EUROPEAN PATENT APPLICATION

(11) **EP 4 607 218 A1**
(43) Date of publication of application: **27.08.2025**
(21) Application number: 23900804.8
(22) Date of filing: 04.07.2023
(51) Int. Cl.: G01R 31/3835, G01R 31/385, G01R 19/165, G01R 19/30, G01R 31/374, G01R 31/392, G01R 31/367, B60L 58/12

(54) **BATTERY DISCHARGE DIAGNOSIS DEVICE AND OPERATION METHOD THEREFOR**

(30) Priority: 09.12.2022 KR 20220171810
(71) Applicant: LG Energy Solution, Ltd., Seoul 07335 (KR)
(72) Inventor: CHAE, Min Young, Daejeon 34122 (KR)
(74) Representative: Goddar, Heinz J.
(86) International application number: PCT/KR2023/009446
(87) International publication number: WO 2024/122782

(57) **Abstract**

A battery discharge diagnosis apparatus according to an embodiment disclosed herein includes an obtaining unit configured to obtain a voltage of a battery unit, a calculating unit configured to calculate a weighted sum value of a number of times the voltage of the battery unit is sensed in a plurality of different voltage ranges, and a diagnosing unit configured to diagnose a depth of discharge of the battery unit by comparing the weighted sum value with at least one threshold value.

## Description

### [TECHNICAL FIELD]

### CROSS-REFERENCE TO RELATED APPLICATION

This application claims priority to and the benefit of Korean Patent Application No. 10-2022-0171810 filed in the Korean Intellectual Property Office on December 9, 2022, the entire contents of which are incorporated herein by reference.

### TECHNICAL FIELD

Embodiments disclosed herein relate to a battery discharge diagnosis apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

### [DISCLOSURE]

### [TECHNICAL PROBLEM]

Recently, discharge of a vehicle AUX battery frequently occurs due to diversified functions, driver's negligence, an influence of an external environment, etc. Discharge of the vehicle AUX battery may accelerate lifetime degradation due to battery deterioration or cause the electric vehicle not to start, and thus needs to be continuously managed.

In a conventional battery system, when the battery of the parked vehicle is discharged, management for preventing the same is not performed. The battery state of the vehicle and whether the vehicle is discharged may not be known until the driver directly starts the vehicle.

Embodiments disclosed herein aim to provide a battery discharge diagnosis apparatus and an operating method thereof in which a depth of discharge of a battery unit may be diagnosed through a weighted sum value calculated based on a voltage of the battery unit and a plurality of voltage range, thereby previously sensing discharge of the battery unit.

Technical problems of the embodiments disclosed herein are not limited to the above-described technical problems, and other unmentioned technical problems would be clearly understood by one of ordinary skill in the art from the following description.

### [TECHNICAL SOLUTION]

A battery discharge diagnosis apparatus according to an embodiment disclosed herein includes an obtaining unit configured to obtain a voltage of a battery unit, a calculating unit configured to calculate a weighted sum value of a number of times the voltage of the battery unit is sensed in a plurality of different voltage ranges, and a diagnosing unit configured to diagnose a depth of discharge of the battery unit by comparing the weighted sum value with at least one threshold value.

In the battery discharge diagnosis apparatus according to an embodiment disclosed herein, the calculating unit may be further configured to calculate the weighted sum value by summing products of the number of times and a plurality of weight values corresponding to the plurality of voltage ranges.

In the battery discharge diagnosis apparatus according to an embodiment disclosed herein, the calculating unit may be further configured to set a weight value corresponding to the voltage range to be lower for a higher upper limit of the voltage range.

In the battery discharge diagnosis apparatus according to an embodiment disclosed herein, the obtaining unit may be further configured to obtain first voltage values of a plurality of new battery units having use periods being less than or equal to a first reference period and second voltage values of a plurality of old battery units having use periods being greater than a second reference period, and the battery discharge diagnosis apparatus may further include a determining unit configured to determine the plurality of voltage ranges based on the first voltage values and the second voltage values.

In the battery discharge diagnosis apparatus according to an embodiment disclosed herein, the determining unit may be further configured to determine a first voltage range having a maximum value of the first voltage values as an upper limit and a minimum value of the first voltage values as a lower limit, determine a second voltage range having a maximum value of the second voltage values as an upper limit and a minimum value of the second voltage values as a lower limit, determine a target voltage range by excluding the first voltage range from the second voltage range, and determine the plurality of voltage ranges in the target voltage range.

In the battery discharge diagnosis apparatus according to an embodiment disclosed herein, the determining unit may be further configured to determine the plurality of voltage ranges based on a distribution of the second voltage values in the target voltage range.

In the battery discharge diagnosis apparatus according to an embodiment disclosed herein, the obtaining unit may be further configured to obtain a number of times the battery unit is charged by another battery unit disposed in the electronic device when the electronic device is in a powered-off state, and the battery discharge diagnosis apparatus may further include a correcting unit configured to additionally correct the depth of discharge based on the number of times the battery unit is charged.

The battery discharge diagnosis apparatus according to an embodiment disclosed herein may further include a correcting unit configured to identify a time for which a voltage of the battery unit is maintained as a designated voltage or less and to additionally correct the depth of discharge based on the identified time.

A battery discharge diagnosis method according to an embodiment disclosed herein includes obtaining a voltage of a battery unit, calculating a weighted sum value of a number of times the voltage of the battery unit is sensed in a plurality of different voltage ranges, and diagnosing a depth of discharge of the battery unit by comparing the weighted sum value with at least one threshold value.

In the battery discharge diagnosis method according to an embodiment disclosed herein, the calculating of the weighted sum value may include calculating the weighted sum value by summing products of the number of times and a plurality of weight values corresponding to the plurality of voltage ranges.

The battery discharge diagnosis method according to an embodiment disclosed herein may further include setting a weight value corresponding to the voltage range to be lower for a higher upper limit of the voltage range.

The battery discharge diagnosis method according to an embodiment disclosed herein may further include obtaining first voltage values of a plurality of new battery units having use periods being less than or equal to a first reference period and second voltage values of a plurality of old battery units having use periods being greater than a second reference period and determining the plurality of voltage ranges based on the first voltage values and the second voltage values.

In the battery discharge diagnosis method according to an embodiment disclosed herein, the determining of the plurality of voltage ranges may include determining a first voltage range having a maximum value of the first voltage values as an upper limit and a minimum value of the first voltage values as a lower limit, determining a second voltage range having a maximum value of the second voltage values as an upper limit and a minimum value of the second voltage values as a lower limit, determining a target voltage range by excluding the first voltage range from the second voltage range, and determining the plurality of voltage ranges in the target voltage range.

In the battery discharge diagnosis method according to an embodiment disclosed herein, the determining of the plurality of voltage ranges may include determining the plurality of voltage ranges based on a distribution of the second voltage values in the target voltage range.

The battery discharge diagnosis method according to an embodiment disclosed herein may further include obtaining a number of times the battery unit is charged by another battery unit disposed in the electronic device when the electronic device is in a powered-off state and additionally correcting the depth of discharge based on the number of times the battery unit is charged.

### [ADVANTAGEOUS EFFECTS]

The battery discharge diagnosis apparatus and the operating method thereof according to various embodiments disclosed herein may previously sense discharge of a battery unit, thereby preventing a situation where a vehicle does not start suddenly.

The effects of the battery abnormality diagnosis apparatus and the operating method thereof according to the disclosure of the present document are not limited to the effects mentioned above, and other effects not mentioned will be clearly understood by those of ordinary skill in the art according to the disclosure of the present document.

Moreover, various effects recognized directly or indirectly from the disclosure may be provided.

### [DESCRIPTION OF DRAWINGS]

FIG. 1 is a block diagram of a battery discharge diagnosis apparatus according to an embodiment.
FIG. 2 is a graph showing a voltage of a battery unit, obtained by a battery discharge diagnosis apparatus according to an embodiment.
FIG. 3 is a graph showing an example where a battery discharge diagnosis apparatus according to an embodiment determines a target voltage range.
FIG. 4 is a graph showing an example where a battery discharge diagnosis apparatus according to an embodiment determines a plurality of voltage ranges.
FIG. 5 is a graph showing an example where a battery discharge diagnosis apparatus according to an embodiment calculates a weighted sum value.
FIG. 6 is an operating flowchart of a battery discharge diagnosis apparatus according to an embodiment.
FIG. 7 is an operating flowchart of a battery discharge diagnosis apparatus according to an embodiment.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

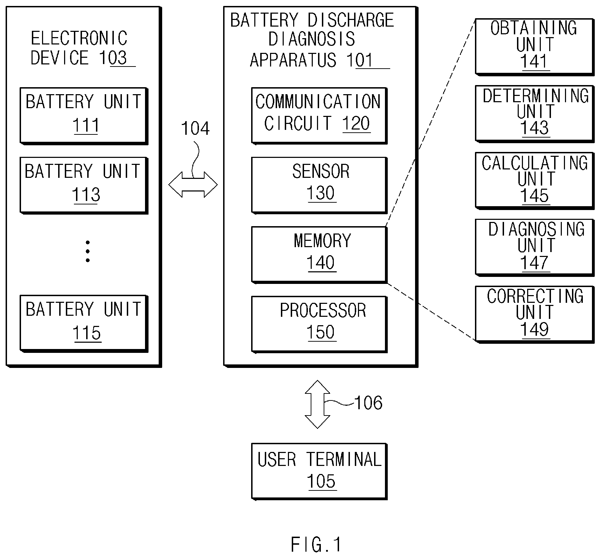

FIG. 1 is a block diagram of a battery discharge diagnosis apparatus according to an embodiment.

Referring to FIG. 1, a battery discharge diagnosis apparatus 101 may be wiredly and/or wirelessly connected to an electronic device 103 and a user terminal 105.

According to an embodiment, connection 104 between the battery discharge diagnosis apparatus 101 and the electronic device 103 may be communication connection through a wired and/or wireless network. According to an embodiment, the wired network may be based on a local area network (LAN) communication or a power-line communication. According to an embodiment, the wireless network may be based on a short-range communication network (e.g., Bluetooth, Wireless Fidelity (WiFi), or Infrared Data Association (IrDA)) or a remote-range communication network (e.g., a cellular network, a 4^{th}-Generation (4G) network, a 5^{th}-Generation (5G) network).

According to another embodiment, the connection 104 between the battery discharge diagnosis apparatus 101 and the electronic device 103 may be connection using a device-to-device communication scheme (e.g., a bus, a general-purpose input and output (GPIO), a serial peripheral interface (SPI), or a mobile industry processor interface (MIPI)).

According to an embodiment, connection 106 between the battery discharge diagnosis apparatus 101 and the user terminal 105 may be communication connection through a wired and/or wireless network.

According to an embodiment, the electronic device 103 may be a mobile device (e.g., a mobile phone, a laptop computer, a smart phone, a smart pad), en electric vehicle (e.g., an electric vehicle (EV), a hybrid EV (HEV), a plug-in HEV (PHEV), a fuel cell EV (FCEV)), an energy storage system (ESS), or a battery swapping system (BSS).

According to an embodiment, the electronic device 103 may include one or more battery units 111, 113, and 115. For example, when the electronic device 103 is an electric vehicle, the one or more battery units 111, 113, and 115 may be vehicle AUX batteries. Herein, each of the one or more battery units 111, 113, and 115 may be a battery cell, a battery module, a battery pack, or a battery rack.

According to an embodiment, the user terminal 105 may be a mobile device (e.g., a mobile phone, a laptop computer, a smart phone, a smart pad), or a personal computer (PC).

According to an embodiment, the battery discharge diagnosis apparatus 101 may include a communication circuit 120, a sensor 130, a memory 140, and a processor 150. According to an embodiment, the battery discharge diagnosis apparatus 101 shown in FIG. 1 may further include at least one component (e.g., a display, an input device, or an output device) in addition to components shown in FIG. 1.

According to an embodiment, the communication circuit 120 may establish a wired communication channel and/or a wireless communication channel between the battery discharge diagnosis apparatus 101 and the electronic device 103 and/or the user terminal 105, and transmit and receive data to and from the electronic device 103 and/or the user terminal 105 through the established communication channel.

According to an embodiment, the communication circuit 120 may establish a wired communication channel and/or a wireless communication channel between the battery discharge diagnosis apparatus 101 and an external server, and transmit and receive data to and from the external server through the established communication channel.

According to an embodiment, the sensor 130 may obtain values related to states of the battery units 111, 113, and 115 of the electronic device 103. According to an embodiment, the values related to the states may indicate one or more values of voltages, currents, resistances, states of charge (SoC), states of health (SoH), or temperatures of the battery units 111, 113, and 115 or combinations thereof. Hereinbelow, the value related to the state may be referred to as a 'state value'.

According to an embodiment, the memory 140 may include a volatile and/or a nonvolatile memory.

According to an embodiment, the memory 140 may store data used by at least one component (e.g., the processor 150) of the battery discharge diagnosis apparatus 101. For example, the data may include software (or an instruction related thereto), input data, or output data. According to an embodiment, the instruction, when executed by the processor 150, may cause the battery abnormality diagnosis apparatus 101 to perform operations defined by the instruction.

According to an embodiment, the memory 140 may include one or more software (e.g., an obtaining unit 141, a determining unit 143, a calculating unit 145, a diagnosing unit 147, and a correcting unit 149).

According to an embodiment, the processor 150 may include a central processing unit, an application processor, a graphic processing unit, a neural processing unit (NPU), an image signal processor, a sensor hub processor, or a communication processor.

According to an embodiment, the processor 150 may execute software (e.g., the obtaining unit 141, the determining unit 143, the calculating unit 145, the diagnosing unit 147, and the correcting unit 149) to control at least one other component (e.g., a hardware or software component) of the battery discharge diagnosis apparatus 101 connected to the processor 150 and perform various data processing or operations.

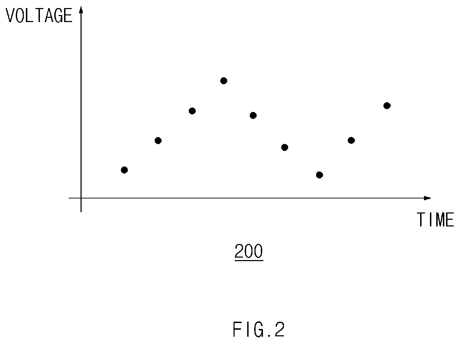

Hereinbelow, referring to FIGS. 2 to 5, a description will be made of a method, performed by the battery discharge diagnosis apparatus 101, of diagnosing depths of discharge of the battery units 111, 113, and 115 through the obtaining unit 141, the determining unit 143, the calculating unit 145, the diagnosing unit 147, and/or the correcting unit 149.

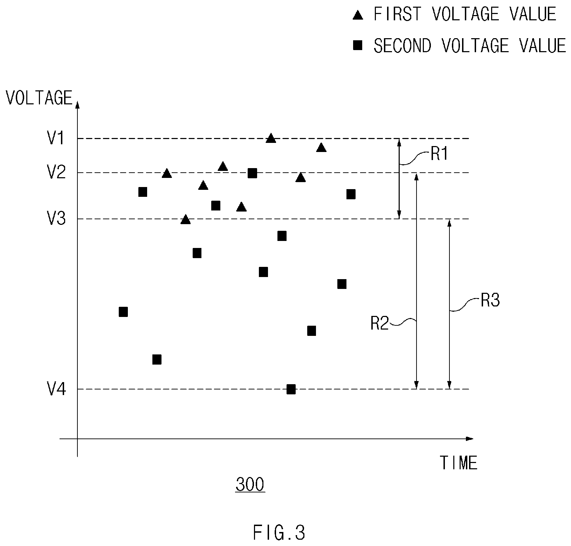

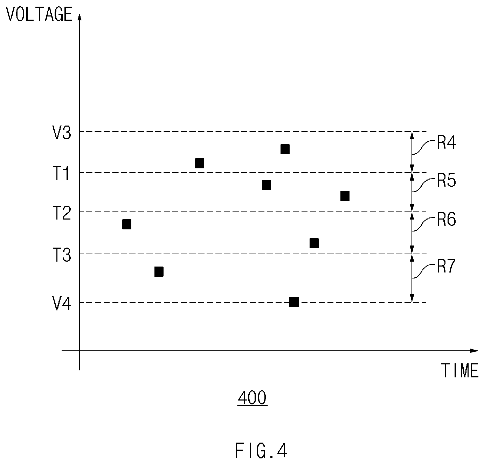

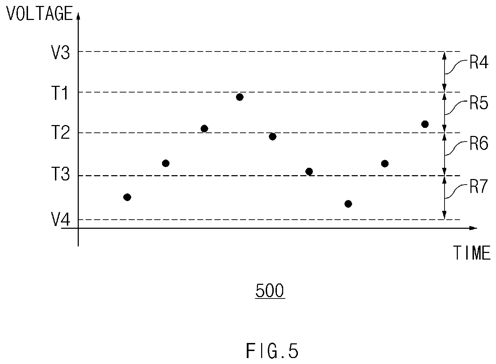

FIG. 2 is a graph showing a voltage of a battery unit, obtained by a battery discharge diagnosis apparatus according to an embodiment. FIG. 3 is a graph showing an example where a battery discharge diagnosis apparatus according to an embodiment determines a target voltage range. FIG. 4 is a graph showing an example where a battery discharge diagnosis apparatus according to an embodiment determines a plurality of voltage ranges. FIG. 5 is a graph showing an example where a battery discharge diagnosis apparatus according to an embodiment calculates a weighted sum value. FIGS. 2, 3, 4, and 5 will be described using the components of FIG. 1.

According to an embodiment, the obtaining unit 141 may obtain a voltage of the battery unit 111, 113, or 115. According to an embodiment, the obtaining unit 141 may obtain a voltage profile indicating a voltage value of the battery unit 111, 113, or 115 with respect to time.

According to an embodiment, the obtaining unit 141 may obtain the voltage of the battery unit 111, 113, or 115 through the electronic device 103 connected through a wired and/or wireless network.

Referring to FIG. 2, a graph 200 indicating a voltage value of the battery unit 111, 113, or 115 with respect to time may be seen. According to an embodiment, the obtaining unit 141 may discretely obtain the voltage of the battery unit 111, 113, or 115, like the graph 200.

According to an embodiment, the obtaining unit 141 may obtain first voltage values of a plurality of new battery units having use periods being less than or equal to a first reference period and second voltage values of a plurality of old battery units having use periods being greater than a second reference period. Herein, the plurality of new battery units, the plurality of old battery units, and the plurality of battery units 111, 113, and 115 of the electronic device 103 may be battery units of the same model. According to an embodiment, the first reference period and the second reference period may be equal to or different from each other.

According to an embodiment, the obtaining unit 141 may obtain the first voltage values and the second voltage values through the external server connected via a wired and/or wireless network.

Referring to FIG. 3, a graph 300 showing the first voltage values and the second voltage values with respect to the obtained time may be seen. According to an embodiment, the obtaining unit 141 may discretely obtain the first voltage values and the second voltage values, like the graph 300.

According to an embodiment, the obtaining unit 141 may obtain the number of times the battery unit 111, 113, or 115 is charged by another battery unit disposed in the electronic device 103 when the electronic device 103 is in a powered-off state. Herein, the other battery unit may be a battery unit separate from the at least one battery unit 111, 113, and 115 shown in FIG. 1. For example, the other battery unit may include a high-voltage and/or a low-voltage battery. According to an embodiment, the obtaining unit 141 may obtain the number of times the battery unit 111, 113, or 115 is charged by another battery unit disposed in the electronic device 103 through the electronic device 103 connected through a wire and/or wireless network, when the electronic device 103 is in the powered-off state.

According to an embodiment, the determining unit 143 may determine a plurality of different voltage ranges. According to an embodiment, the determining unit 143 may determine the plurality of voltage ranges based on the first voltage values and the second voltage values, obtained by the obtaining unit 141.

For example, referring to FIG. 3, the determining unit 143 may determine a first voltage range R1 having a maximum value V1 of the first voltage values as an upper limit and a minimum value V3 of the first voltage values as a lower limit. The determining unit 143 may also determine a second voltage range R2 having a maximum value V2 of the second voltage values as an upper limit and a minimum value V4 of the second voltage values as a lower limit. The determining unit 143 may determine a target voltage range R3 by excluding the first voltage range R1 from the second voltage range R2.

According to an embodiment, the determining unit 143 may determine a plurality of voltage ranges in the target voltage range R3. According to an embodiment, the determining unit 143 may determine a plurality of voltage ranges based on a distribution of the second voltage values in the target voltage range R3.

According to an embodiment, the determining unit 143 may determine a plurality of voltage ranges, each including a designated number of second voltage values in the target voltage range. For example, referring to FIG. 4. the determining unit 143 may determine a plurality of voltage ranges R4, R5, R6, and R7, each including two second voltage values, in the target voltage range. While it is shown in FIG. 4 that each of the plurality of voltage ranges R4, R5, R6, and R7 includes two second voltage values, the designated number may be set variously without being limited thereto.

According to an embodiment, the calculating unit 145 may calculate a weighted sum value of the number of times the voltage of the battery unit 111, 113, or 115 is sensed in the plurality of voltage ranges. Herein, the plurality of voltage ranges may be stored in the memory 140 or determined by the determining unit 143.

According to an embodiment, the calculating unit 145 may calculate a weighted sum value by summing products of the numbers of times and a plurality of weight values corresponding to the plurality of voltage ranges.

For example, according to a graph 500 of FIG. 5, the calculating unit 145 may calculate, as a first multiplication value, a product, 0, of a weight value of 0 corresponding to the voltage range R4 (a voltage range being at least T1 but less than V3) and the number of times the voltage of the battery unit 111, 113, or 115 is sensed in the voltage range R4, 0. The calculating unit 145 may calculate, as a second multiplication value, a product, 3, of a weight value of 1 corresponding to the voltage range R5 (a voltage range being at least T2 but less than T1) and the number of times the voltage of the battery unit 111, 113, or 115 is sensed in the voltage range R5, 3. The calculating unit 145 may calculate, as a third multiplication value, a product, 8, of a weight value of 2 corresponding to the voltage range R6 (a voltage range being at least T3 but less than T2) and the number of times the voltage of the battery unit 111, 113, or 115 is sensed in the voltage range R6, 4. The calculating unit 145 may calculate, as a fourth multiplication value, a product, 8, of a weight value of 4 corresponding to the voltage range R7 (a voltage range being at least V4 but less than T3) and the number of times the voltage of the battery unit 111, 113, or 115 is sensed in the voltage range R7, 2. The calculating unit 145 may calculate, as the weighted sum value, a sum value, 19, of the first multiplication value, the second multiplication value, the third multiplication value, and the fourth multiplication value.

According to an embodiment, the calculating unit 145 may set a weight value corresponding to the voltage range to be lower for a higher upper limit of the voltage range. For example, referring to a graph 500 of FIG. 5, the calculating unit 145 may set a weight value corresponding to the voltage range R4 having the highest upper limit to be lowest. The calculating unit 145 may set a weight value corresponding to the voltage range R5 having the second highest upper limit to be lower than weight values corresponding to the voltage ranges R6 and R7. The calculating unit 145 may set a weight value corresponding to the voltage range R6 having the third highest upper limit to be lower than the weight value corresponding to the voltage range R7.

According to an embodiment, the diagnosing unit 147 may diagnose a depth of discharge of the battery unit 111, 113, or 115 by comparing the weighted sum value with at least one threshold value. For example, the diagnosing unit 147 may diagnose the battery unit 111, 113, or 115 as a discharge state when the weighted sum value is greater than or equal to a first threshold value. The diagnosing unit 147 may diagnose the battery unit 111, 113, or 115 as a discharge-risk state when the weighted sum value is greater than or equal to a second threshold value less than the first threshold value, but is less than the first threshold value.

According to an embodiment, the correcting unit 149 may additionally correct a depth of discharge diagnosed by the diagnosing unit 147 based on the number of times the battery unit 111, 113, or 115 is charged by another battery unit disposed in the electronic device 103 when the electronic device 103 is in the powered-off state.

The electronic device 103 may activate a battery saver function that changes the battery unit 111, 113, or 115 by using power stored in the other battery units to prevent the battery unit 111, 113, or 115 from being discharged when the electronic device 103 is in the powered-off state. This battery saver function may be more frequently activated for a higher degree of deterioration. That is, a risk of discharge may increase as the number of times the battery unit 111, 113, or 115 activates the battery saver function. In this regard, the correcting unit 149 may additionally correct a depth of discharge of the battery unit 111, 113, or 115 based on the number of times the battery saver function is activated.

According to an embodiment, the correcting unit 149 may identify a time for which the voltage of the battery unit 111, 113, or 115 is maintained as a designated voltage or less. The correcting unit 149 may additionally correct the depth of discharge diagnosed by the diagnosing unit 147 based on the identified time. For example, the correcting unit 149 may correct a depth of discharge by regarding the risk of discharge of the battery unit 111, 113, or 115 as being high for a longer time for which the voltage of the battery unit 111, 113, or 115 is maintained as the designated voltage or less. Herein, the designated voltage may be set variously according to specifications of the battery unit 111, 113, or 115.

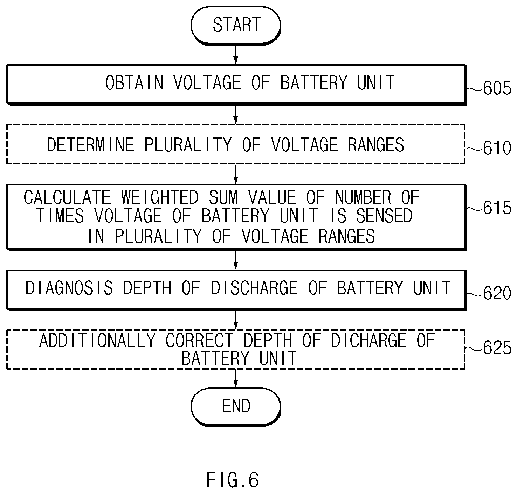

FIG. 6 is an operating flowchart of a battery discharge diagnosis apparatus according to an embodiment. FIG. 6 will be described using components of FIG. 1.

The embodiment shown in FIG. 6 may be an example, and an order of operations according to various embodiments of the present disclosure may be different from that shown in FIG. 6, and some operations shown in FIG. 6 may be omitted, the order of the operations may be changed, or the operations may be merged. For example, in FIG. 6, operation 610 and/or operation 625 may be omitted.

Referring to FIG. 6, in operation 605, the battery discharge diagnosis apparatus 101 may obtain a voltage of the battery unit 111, 113, or 115. According to an embodiment, the battery discharge diagnosis apparatus 101 may obtain a voltage profile indicating a voltage value of the battery unit 111, 113, or 115 with respect to time. According to an embodiment, the battery discharge diagnosis apparatus 101 may discretely obtain a voltage of the battery unit 111, 113, or 115.

In operation 610, the battery discharge diagnosis apparatus 101 may determine a plurality of different voltage ranges. According to an embodiment, the battery discharge diagnosis apparatus 101 may determine the plurality of voltage values based on the first voltage values of the plurality of new battery units having use periods being less than or equal to the first reference period and the second voltage values of the plurality of old battery units having use periods being greater than the second reference period.

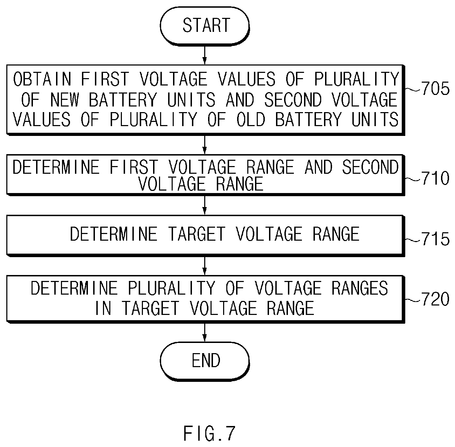

Operation 610, performed by the battery discharge diagnosis apparatus 101, of determining the plurality of different voltage ranges will be described in detail with reference to FIG. 7.

In operation 615, the battery discharge diagnosis apparatus 101 may calculate a weighted sum value of the number of times the voltage of the battery unit 111, 113, or 115 is sensed in the plurality of voltage ranges. Herein, the plurality of voltage ranges may be stored in the memory 140 or determined in operation 610.

According to an embodiment, the battery discharge diagnosis apparatus 101 may calculate a weighted sum value by summing products of the numbers of times and a plurality of weight values corresponding to the plurality of voltage ranges. According to an embodiment, the battery discharge diagnosis apparatus 101 may set a weight value corresponding to the voltage range to be lower for a higher upper limit of the voltage range.

In operation 620, the battery discharge diagnosis apparatus 101 may diagnose a depth of discharge of the battery unit 111, 113, or 115 by comparing the weighted sum value with at least one threshold value. For example, the battery discharge diagnosis apparatus 101 may diagnose the battery unit 111, 113, or 115 as a discharge state when the weighted sum value is greater than or equal to a first threshold value. The battery discharge diagnosis apparatus 101 may diagnose the battery unit 111, 113, or 115 as a discharge-risk state when the weighted sum value is greater than or equal to a second threshold value less than the first threshold value, but is less than the first threshold value.

In operation 625, the battery discharge diagnosis apparatus 101 may additionally a depth of discharge of the battery unit 111, 113, or 115.

According to an embodiment, the battery discharge diagnosis apparatus 101 may additionally correct the depth of discharge diagnosed in operation 620 based on the number of times the battery unit 111, 113, or 115 is charged by another battery unit disposed in the electronic device 103 when the electronic device 103 is in the powered-off state.

According to an embodiment, the battery discharge diagnosis apparatus 101 may identify a time for which the voltage of the battery unit 111, 113, or 115 is maintained as a designated voltage or less. The battery discharge diagnosis apparatus 101 may additionally correct the depth of discharge diagnosed in operation 620, based on the identified time. For example, the battery discharge diagnosis apparatus 101 may correct a depth of discharge by regarding the risk of discharge of the battery unit 111, 113, or 115 as being high for a longer time for which the voltage of the battery unit 111, 113, or 115 is maintained as the designated voltage or less. Herein, the designated voltage may be set variously according to specifications of the battery unit 111, 113, or 115.

FIG. 7 is an operating flowchart of a battery discharge diagnosis apparatus according to an embodiment. FIG. 7 will be described using components of FIG. 1.

The embodiment shown in FIG. 7 may be an example, and an order of operations according to various embodiments of the present disclosure may be different from that shown in FIG. 7, and some operations shown in FIG. 7 may be omitted, the order of the operations may be changed, or the operations may be merged.

Referring to FIG. 7, in operation 705, the battery discharge diagnosis apparatus 101 may obtain the first voltage values of the plurality of new battery units and the second voltage values of the plurality of old battery units, Herein, the use periods of the plurality of new battery units may be the first reference period or less, and the use periods of the plurality of old battery units may exceed the second reference period. The plurality of new battery units, the plurality of old battery units, and the plurality of battery units 111, 113, and 115 of the electronic device 103 may be battery units of the same model. According to an embodiment, the first reference period and the second reference period may be equal to or different from each other.

According to an embodiment, the battery discharge diagnosis apparatus 101 may discretely obtain the first voltage values and the second voltage values.

In operation 710, the battery discharge diagnosis apparatus 101 may determine the first voltage range and the second voltage range.

According to an embodiment, the battery discharge diagnosis apparatus 101 may determine the first voltage range having the maximum value of the first voltage values obtained in operation 705 as an upper limit and the minimum value of the first voltage values as a lower limit. The battery discharge diagnosis apparatus 101 may determine the second voltage range having the maximum value of the second voltage values as an upper limit and the minimum value of the second voltage values as a lower limit.

In operation 715, the battery discharge diagnosis apparatus 101 may determine a target voltage range. According to an embodiment, the battery discharge diagnosis apparatus 101 may determine the target voltage range by excluding the first voltage range from the second voltage range.

In operation 720, the battery discharge diagnosis apparatus 101 may determine the plurality of voltage ranges in the target voltage range determined in operation 715.

According to an embodiment, the battery discharge diagnosis apparatus 101 may determine the plurality of voltage ranges based on a distribution of the second voltage values in the target voltage range. According to an embodiment, the battery discharge diagnosis apparatus 101 may determine the plurality of voltage ranges, each including a designated number of second voltage values in the target voltage range.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. A battery discharge diagnosis apparatus comprising:
an obtaining unit configured to obtain a voltage of a battery unit;
a calculating unit configured to calculate a weighted sum value of a number of times the voltage of the battery unit is sensed in a plurality of different voltage ranges; and
a diagnosing unit configured to diagnose a depth of discharge of the battery unit by comparing the weighted sum value with at least one threshold value.

2. The battery discharge diagnosis apparatus of claim 1, wherein the calculating unit is further configured to calculate the weighted sum value by summing products of the number of times and a plurality of weight values corresponding to the plurality of voltage ranges.

3. The battery discharge diagnosis apparatus of claim 2, wherein the calculating unit is further configured to set a weight value corresponding to the voltage range to be lower for a higher upper limit of the voltage range.

4. The battery discharge diagnosis apparatus of claim 1, wherein the obtaining unit is further configured to obtain first voltage values of a plurality of new battery units having use periods being less than or equal to a first reference period and second voltage values of a plurality of old battery units having use periods being greater than a second reference period, and
the battery discharge diagnosis apparatus further comprises a determining unit configured to determine the plurality of voltage ranges based on the first voltage values and the second voltage values.

5. The battery discharge diagnosis apparatus of claim 4, wherein the determining unit is further configured to:
determine a first voltage range having a maximum value of the first voltage values as an upper limit and a minimum value of the first voltage values as a lower limit;
determine a second voltage range having a maximum value of the second voltage values as an upper limit and a minimum value of the second voltage values as a lower limit;
determine a target voltage range by excluding the first voltage range from the second voltage range; and
determine the plurality of voltage ranges in the target voltage range.

6. The battery discharge diagnosis apparatus of claim 5, wherein the determining unit is further configured to determine the plurality of voltage ranges based on a distribution of the second voltage values in the target voltage range.

7. The battery discharge diagnosis apparatus of claim 1, wherein the obtaining unit is further configured to obtain a number of times the battery unit is charged by another battery unit disposed in the electronic device when the electronic device is in a powered-off state, and
the battery discharge diagnosis apparatus further comprises a correcting unit configured to additionally correct the depth of discharge based on the number of times the battery unit is charged.

8. The battery discharge diagnosis apparatus of claim 1, further comprising a correcting unit configured to identify a time for which a voltage of the battery unit is maintained as a designated voltage or less and to additionally correct the depth of discharge based on the identified time.

9. A battery discharge diagnosis method comprising:
obtaining a voltage of a battery unit;
calculating a weighted sum value of a number of times the voltage of the battery unit is sensed in a plurality of different voltage ranges; and
diagnosing a depth of discharge of the battery unit by comparing the weighted sum value with at least one threshold value.

10. The battery discharge diagnosis method of claim 9, wherein the calculating of the weighted sum value comprises calculating the weighted sum value by summing products of the number of times and a plurality of weight values corresponding to the plurality of voltage ranges.

11. The battery discharge diagnosis method of claim 10, further comprising setting a weight value corresponding to the voltage range to be lower for a higher upper limit of the voltage range.

12. The battery discharge diagnosis method of claim 9, further comprising:
obtaining first voltage values of a plurality of new battery units having use periods being less than or equal to a first reference period and second voltage values of a plurality of old battery units having use periods being greater than a second reference period; and
determining the plurality of voltage ranges based on the first voltage values and the second voltage values.

13. The battery discharge diagnosis method of claim 12, wherein the determining of the plurality of voltage ranges comprises:
determining a first voltage range having a maximum value of the first voltage values as an upper limit and a minimum value of the first voltage values as a lower limit;
determining a second voltage range having a maximum value of the second voltage values as an upper limit and a minimum value of the second voltage values as a lower limit;
determining a target voltage range by excluding the first voltage range from the second voltage range; and
determining the plurality of voltage ranges in the target voltage range.

14. The battery discharge diagnosis method of claim 13, wherein the determining of the plurality of voltage ranges comprises determining the plurality of voltage ranges based on a distribution of the second voltage values in the target voltage range.

15. The battery discharge diagnosis method of claim 9, further comprising:
obtaining a number of times the battery unit is charged by another battery unit disposed in the electronic device when the electronic device is in a powered-off state; and
additionally correcting the depth of discharge based on the number of times the battery unit is charged.
